(19) **Europäisches Patentamt** / **European Patent Office** / **Office européen des brevets**

(11) **EP 4 572 122 A1**

(12) ## DEMANDE DE BREVET EUROPEEN

(43) Date de publication:
**18.06.2025 Bulletin 2025/25**

(21) Numéro de dépôt: **24217001.7**

(22) Date de dépôt: **03.12.2024**

(51) Classification Internationale des Brevets (IPC):
**H02M 7/5387** (2007.01)   **H02M 1/12** (2006.01)
**G01R 31/40** (2020.01)   **H02M 7/487** (2007.01)

(52) Classification Coopérative des Brevets (CPC):
**H02M 1/126; G01R 31/40; H02M 7/5387;**
G01R 31/72; H02M 7/4837; H02M 7/487

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH MA MD TN**

(30) Priorité: **12.12.2023 FR 2313970**

(71) Demandeur: **Commissariat à l'Energie Atomique et aux Energies Alternatives**
**75015 Paris (FR)**

(72) Inventeurs:
• **ALVES RODRIGUES, Luis-Gabriel**
**38054 GRENOBLE CEDEX 09 (FR)**
• **CATELLANI, Stéphane**
**38054 GRENOBLE CEDEX 09 (FR)**

(74) Mandataire: **Cabinet Beaumont**
**4, Place Robert Schuman**
**B.P. 1529**
**38025 Grenoble Cedex 1 (FR)**

(54) **CONVERTISSEUR STATIQUE DE PUISSANCE CONFIGURE POUR MESURER UNE VALEUR D'UNE INDUCTANCE DE FILTRAGE**

(57)     La présente description concerne un convertisseur statique de puissance (100), comportant au moins :
- une cellule de commutation (102.1 - 102.3) comprenant au moins des premier et deuxième interrupteurs de commutation (104, 106) ;
- une première inductance (113) couplée à une sortie de la cellule de commutation ;
- un premier interrupteur de mesure (122) tel que la première inductance soit couplée entre le premier interrupteur de mesure et la cellule de commutation ;
- un circuit de pilotage (126) configuré pour commander au moins une fermeture du premier interrupteur de mesure lors d'une mesure d'une valeur de la première inductance.

**Fig. 1**

EP 4 572 122 A1

**Description**

<u>Domaine technique</u>

La présente description concerne de façon générale le domaine de la conversion électrique de puissance, et notamment celui des convertisseurs statiques de puissance. La présente description porte également sur les systèmes de puissance faisant appel à des convertisseurs statiques de puissance, comme par exemple celui des systèmes photo-voltaïques.

<u>Technique antérieure</u>

Un système de puissance tel qu'un système de production d'énergie photovoltaïque comporte au moins un dispositif de conversion d'énergie photovoltaïque. Cette énergie photovoltaïque produite sous la forme d'un signal électrique continu est convertie en un signal électrique alternatif. Cette conversion est assurée par au moins un convertisseur statique de puissance DC/AC également appelé onduleur.

Les pannes survenant dans un système de production d'énergie photovoltaïque sont souvent dues à l'onduleur. Plus précisément, des défaillances sur les composants formant un circuit de filtrage en sortie de l'onduleur sont souvent à l'origine d'une partie non négligeable de ces pannes.

Le circuit de filtrage de l'onduleur comporte généralement au moins une inductance, et correspond par exemple à un filtre de type LCL (inductance - capacité - inductance) présent en sortie de chaque phase de l'onduleur. Dans une inductance, la dégradation dans le temps de son isolant peut engendrer par exemple un court-circuit de certaines spires de l'inductance, ce qui peut avoir pour conséquence une saturation de l'inductance pouvant engendrer des défaillances d'autres composants de l'onduleur tels que des IGBT des cellules de commutation de l'onduleur.

<u>Résumé de l'invention</u>

Il existe un besoin de proposer une solution permettant d'identifier les éventuelles défaillances de la ou des inductances du ou des circuits de filtrage au sein d'un convertisseur statique de puissance, voire de suivre l'état de santé de ces inductances.

Pour cela, il est proposé un convertisseur statique de puissance, comportant au moins :

- une cellule de commutation comprenant au moins des premier et deuxième interrupteurs de commutation ;

- une première inductance couplée à une sortie de la cellule de commutation ;

- un premier interrupteur de mesure tel que la première inductance soit couplée entre le premier interrupteur de mesure et la cellule de commutation ;

- un circuit de pilotage configuré pour commander au moins une fermeture du premier interrupteur de mesure lors d'une mesure d'une valeur de la première inductance.

Selon un mode de réalisation particulier, le convertisseur statique de puissance comporte en outre au moins :

- un élément capacitif couplé électriquement en parallèle de la cellule de commutation et sur lequel une tension d'entrée est destinée à être appliquée ;

- un circuit de mesure de courant configuré pour mesurer un courant destiné à traverser la première inductance ;

et :

- la cellule de commutation comprend un noeud central auquel les premier et deuxième interrupteurs de commutation sont couplés électriquement ;

- la première inductance comprend une première électrode couplée au noeud central de la cellule de commutation ;

- le premier interrupteur de mesure est couplé électriquement entre une deuxième électrode de la première inductance et l'élément capacitif ;

- le circuit de pilotage est configuré pour commander les interrupteurs de commutation et le premier interrupteur de mesure tel que lors d'une première partie de la mesure de la valeur de la première inductance, le premier interrupteur de mesure et le premier interrupteur de commutation sont fermés.

Selon un mode de réalisation particulier, le circuit de pilotage est configuré pour commander les interrupteurs de commutation et le premier interrupteur de mesure tel que lors d'une deuxième partie de la mesure de la valeur de la première inductance, le premier interrupteur de mesure est fermé et le premier interrupteur de commutation est ouvert.
Selon un mode de réalisation particulier, le convertisseur statique de puissance comporte en outre un circuit de calcul de la valeur de la première inductance à partir de la valeur de la tension d'entrée et du courant mesuré par le circuit de mesure de courant lors de la première partie de la mesure de la valeur de la première inductance et/ou lors de la deuxième partie de la mesure de la valeur de la première inductance.
Selon un mode de réalisation particulier, le circuit de calcul est configuré pour calculer la valeur de la première inductance selon l'équation :

$$L_{calc} = V_{cbus} \times \frac{\Delta t}{\Delta i}$$

avec $V_{cbus}$ correspondant à la tension d'entrée aux bornes de l'élément capacitif avant la mesure de la valeur de la première inductance ;

$\Delta i$ correspondant à une variation de courant mesurée par le circuit de mesure de courant ;

$\Delta t$ correspondant à une durée pendant laquelle la variation de courant $\Delta i$ est mesurée.

Selon un mode de réalisation particulier, le circuit de mesure de courant est configuré pour mesurer le courant au cours de la première partie de la mesure de la valeur de la première inductance.
Selon un mode de réalisation particulier, le circuit de calcul est configuré pour comparer la valeur calculée de la première inductance à au moins une valeur nominale de la première inductance et/ou à au moins une précédente valeur calculée de la première inductance.
Selon un mode de réalisation particulier, le circuit de calcul est configuré pour calculer, avant la mesure de la valeur de la première inductance, une durée $T_{on}$ de la première partie de la mesure de la valeur de la première inductance telle que :

$$T_{on} = \alpha \times \frac{L_{initiale} \times \Delta Imax}{V_{cbus}}$$

avec $L_{initiale}$ correspondant à la valeur initiale de la première inductance ;

$\Delta Imax$ correspondant à la valeur maximale du courant destiné à traverser la première inductance lors de la première partie de la mesure de la valeur de la première inductance ;

$\alpha$ correspondant à un coefficient supérieur à 0, et inférieur ou égal à 1.

Selon un mode de réalisation particulier, le convertisseur statique de puissance comporte en outre un circuit de mesure de tension configuré pour mesurer la tension d'entrée destinée à être appliquée sur l'élément capacitif, et le circuit de pilotage est configuré pour débuter la mesure de la valeur de la première inductance lorsque la tension d'entrée mesurée est supérieure à une valeur seuil.
Selon un mode de réalisation particulier, l'élément capacitif comporte au moins deux capacités couplées électriquement en série au niveau d'un noeud, et ledit noeud est couplé à un potentiel électrique de référence.
Selon un mode de réalisation particulier :

- la première inductance fait partie d'un filtre de type LCL comportant en outre une deuxième inductance dont une première électrode est couplée à la deuxième électrode de la première inductance ;

- le convertisseur statique de puissance comporte en outre un deuxième interrupteur de mesure couplé électriquement entre une deuxième électrode de la deuxième inductance et l'élément capacitif ;

- le circuit de pilotage est configuré pour commander également le deuxième interrupteur de mesure tel que :

    o lors des première et deuxième parties de la mesure de la valeur de la première inductance, le deuxième interrupteur de mesure est ouvert ;

    o lors d'une première partie d'une mesure de la deuxième inductance, le premier interrupteur de mesure est ouvert, et le premier interrupteur de commutation et le deuxième interrupteur de mesure sont fermés.

Selon un mode de réalisation particulier, le circuit de pilotage est configuré pour commander le deuxième interrupteur de mesure tel que lors d'une deuxième partie de la mesure de la deuxième inductance, le premier interrupteur de mesure et le premier interrupteur de commutation sont ouverts, et le deuxième interrupteur de mesure est fermé.

Selon un mode de réalisation particulier, le convertisseur statique de puissance comporte :

- trois cellules de commutation comprenant chacune un noeud central et au moins des premier et deuxième interrupteurs de commutation couplés électriquement en série l'un à l'autre, chacune étant couplée électriquement en parallèle de l'élément capacitif ;

- trois premières inductances comprenant chacune une première électrode couplée au noeud central de l'une des cellules de commutation ;

- trois circuits de mesure de courant chacun configuré pour mesurer un courant destiné à traverser l'une des trois premières inductances ;

- trois premiers interrupteurs de mesure chacun couplé électriquement entre une deuxième électrode de l'une des premières inductances et l'élément capacitif ;

et le circuit de pilotage est configuré pour mesurer chacune des premières inductances et pour commander les interrupteurs de commutation et les premiers interrupteurs de mesure tel que lors d'une première partie d'une mesure de la valeur de l'une des premières inductances, le premier interrupteur de mesure et le premier interrupteur de commutation couplés à ladite une des premières inductances sont fermés, et lors d'une deuxième partie de la mesure de la valeur de ladite une des premières inductances, le premier interrupteur de mesure couplé à ladite une des premières inductances est fermé et le premier interrupteur de commutation couplé à ladite une des premières inductances est ouvert.

Selon un mode de réalisation particulier, les premiers interrupteurs de mesure sont configurés pour être commandés par un même signal de commande.

Selon un mode de réalisation particulier, le convertisseur statique de puissance est configuré pour réaliser une mesure de la valeur de la première inductance à des intervalles de temps réguliers, par exemple quotidiennement ou à intervalles de plusieurs jours.

Selon un mode de réalisation particulier, le convertisseur statique de puissance est un convertisseur multiniveau, par exemple de type NPC ou à condensateurs flottants, et fonctionnant en tant qu'onduleur ou redresseur de tension et/ou courant.

Il est également proposé un système photovoltaïque comprenant au moins un panneau photovoltaïque couplé à un convertisseur statique de puissance selon un mode de réalisation particulier.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 représente schématiquement un premier exemple de convertisseur statique de puissance selon un mode de réalisation particulier ;

la figure 2 représente schématiquement des signaux électriques de test obtenus sur une inductance du convertisseur statique de puissance selon un mode de réalisation particulier ;

la figure 3 représente schématiquement un deuxième exemple de convertisseur statique de puissance selon un mode de réalisation particulier ;

la figure 4 représente schématiquement un troisième exemple de convertisseur statique de puissance selon un mode de réalisation particulier ;

la figure 5 représente schématiquement un quatrième exemple de convertisseur statique de puissance selon un mode de réalisation particulier ;

la figure 6 représente schématiquement un cinquième exemple de convertisseur statique de puissance selon un mode de réalisation particulier ;

la figure 7 représente schématiquement un sixième exemple de convertisseur statique de puissance selon un mode de réalisation particulier.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, la réalisation des différents éléments, composants et circuits (composants des cellules de commutation, circuit de pilotage, circuits de mesure de courant et de tension, circuit de calcul, etc.) n'est pas détaillée. L'homme du métier sera à même de réaliser de manière détaillée les différentes fonctions décrites à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures ou à un ... dans une position normale d'utilisation.

Sauf précision contraire, les expressions "environ", "approximativement", "sensiblement", et "de l'ordre de" signifient à 10 % près, de préférence à 5 % près.

L'état fermé, ou état passant ou saturé, correspond à l'état dans lequel un interrupteur laisse passer un courant, et l'état ouvert, ou état bloqué, correspond à l'état dans lequel l'interrupteur ne laisse pas passer de courant.

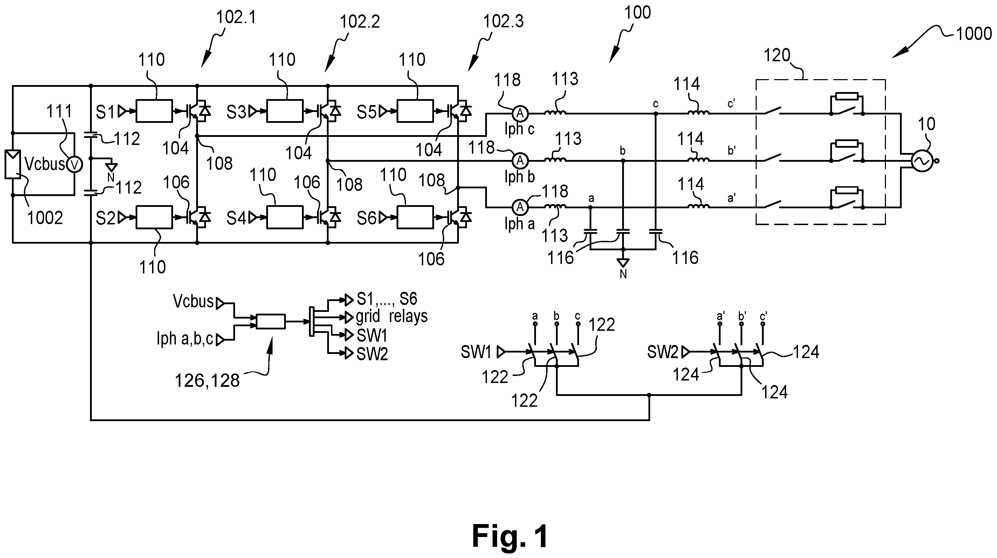

La figure 1 représente schématiquement un premier exemple de réalisation d'un convertisseur statique de puissance 100.

Dans les différents exemples de réalisation décrits ci-dessous, le convertisseur 100 fait partie d'un système photovoltaïque 1000 comprenant au moins un panneau photovoltaïque 1002 destiné à produire un signal électrique continu (un seul panneau photovoltaïque 1002 est mentionné dans la suite de la description, bien que le système 1000 puisse comporter plusieurs panneaux 1002 couplés au convertisseur 100).

Dans le premier exemple décrit, le convertisseur 100 correspond à un onduleur triphasé.

Sur l'exemple de la figure 1, le convertisseur 100 comporte trois cellules de commutation 102.1 - 102.3 chacune destinée à la conversion continu - alternatif du signal électrique produit par le panneau 1002 pour l'une des phases du signal électrique triphasé délivré en sortie du convertisseur 100.

Chacune des cellules de commutation 102.1 - 102.3 comporte au moins un premier interrupteur de commutation 104 et au moins un deuxième interrupteur de commutation 106. Dans l'exemple décrit, chacun des interrupteurs de commutation 104, 106 comporte au moins un transistor de puissance de type IGBT (incluant une diode antiparallèle, ou de « roue-libre », visible sur la figure 1). En variante, chacun des interrupteurs de commutation 104, 106 peut comporter un autre type de transistor de puissance, par exemple de type MOSFET ou autre. Dans chaque cellule de commutation 102.1 - 102.3, les premier et deuxième interrupteurs de commutation 104, 106 sont couplés électriquement l'un à l'autre en série au niveau d'un noeud central 108.

Dans ce premier exemple, les premiers interrupteurs de commutation 104 correspondent aux interrupteurs dits « high-side », ou côté haut, leur point de couplage commun étant la borne positive de la source d'énergie électrique du système 1000. Les deuxièmes interrupteurs de commutation 106 correspondent aux interrupteurs dits « low-side », ou côté bas, leur point de couplage commun étant la borne négative de la source d'énergie électrique du système 1000.

Sur l'exemple de la figure 1, chaque transistor des premier et deuxième interrupteurs de commutation 104, 106 est commandé par un circuit 110 de commande de grille ou d'attaque de grille (« gâte driver » en anglais) couplé électriquement à la grille du transistor. Sur la figure 1, les signaux de commande reçus par les circuits 110 sont appelés

$S_1, ..., S_6$.

Dans le premier exemple décrit, le convertisseur 100 comporte en outre un élément capacitif couplé électriquement en parallèle des cellules de commutation 102.1 - 102.3 et aux bornes duquel une tension d'entrée appelée $V_{cbus}$ est destinée à être appliquée par le panneau 1002. Sur l'exemple de la figure 1, cet élément capacitif comporte deux capacités 112, correspondant par exemple à des condensateurs, couplées électriquement en série par une première de leurs électrodes au niveau d'un noeud formant ici le point milieu du bus assurant la connexion entre le panneau 1002 et l'entrée du convertisseur 100. Ce noeud est ici couplé à un potentiel électrique de référence du convertisseur 100, par exemple la masse. A titre d'exemple, chacune des capacités 112 peut avoir une valeur égale 10 mF.

La tension électrique continue produite par le panneau 1002 est par exemple mesurée par un circuit de mesure de tension 111 du convertisseur 100. Le circuit de mesure de tension 111 correspondant par exemple à un capteur de tension, couplé électriquement en parallèle du panneau 1002 et de l'élément capacitif. En outre, le circuit de mesure de tension 111 est ici configuré pour mesurer la tension d'entrée $V_{cbus}$ obtenue aux bornes de l'élément capacitif.

Le convertisseur 100 selon le premier exemple décrit comporte en outre des circuits de filtrage chacun couplé électriquement au noeud central 108 d'une des cellules des commutation 102.1 - 102.3. Sur l'exemple de la figure 1, le convertisseur 100 comporte trois circuits de filtrage. Ces circuits de filtrage sont destinés à filtrer les harmoniques produites en sortie des cellules de commutation 102.1 - 102.3. Chaque circuit de filtrage comporte au moins une inductance.

Sur l'exemple de la figure 1, les circuits de filtrage sont de type LCL, c'est-à-dire comportent chacun une première inductance 113 couplée en série à une deuxième inductance 114, ainsi qu'une capacité 116 dont une première électrode est couplée au noeud de jonction des deux inductances 113, 114. Dans chacun de ces circuits de filtrage, la première inductance 113 peut être vue comme étant destinée à filtrer les harmoniques haute-fréquence produites par la cellule de commutation à laquelle le circuit de filtrage est couplé, tandis que la deuxième inductance 114 peut être vue comme étant destinée à filtrer les harmoniques basse-fréquence produites par cette cellule de commutation. Selon un exemple, les première et deuxième inductances 113, 114 peuvent comporter des bobines, et les capacités 116 peuvent comporter des condensateurs.

Sur l'exemple de la figure 1, une première électrode de la première inductance 113 de chaque circuit de filtrage est couplée au noeud central 108 de la cellule de commutation 102.1 - 102.3 à laquelle le circuit de filtrage est couplé. Une deuxième électrode de la première inductance 113 de chaque circuit de filtrage est couplée à une première électrode de la deuxième inductance 114 et à la première électrode de la capacité 116 de ce circuit de filtrage. Une deuxième électrode des capacités 116 des circuits de filtrage est couplée au potentiel électrique de référence du convertisseur 100.

Dans le premier exemple décrit, le convertisseur 100 comporte en outre des circuits 118 de mesure de courant (au nombre de trois sur l'exemple de la figure 1) configurés pour mesurer les courants destinés à traverser les premières inductances 113. Les circuits 118 comportent par exemple des capteurs de courant. Sur l'exemple de la figure 1, chaque circuit 118 est interposé entre le noeud central 108 d'une des cellules de commutation 102.1 - 102.3 et l'un des circuits de filtrage, la première électrode de la première inductance 113 de chaque circuit de filtrage étant couplée à l'un des circuits 118. Sur la figure 1, les signaux de mesure des courants délivrés par les circuits 118 sont appelés Iph a, Iph b, Iph c.

Dans le cas où les circuits 118 correspondent à des capteurs de courant, ces capteurs peuvent être tels que leur bande passante soit suffisamment élevée pour mesurer correctement la variation du courant traversant les inductances pendant la mesure de la valeur de ces inductances. Plus la durée pendant laquelle le courant est mesuré est courte, plus la bande passante du capteur de courant est choisie comme étant élevée. A titre d'exemple, la bande passante de chaque capteur de courant peut être égale à 100 kHz.

Le réseau sur lequel les signaux électriques alternatifs sont délivrés en sortie par le convertisseur 100 est représenté symboliquement sur la figure 1 par l'élément désigné par la référence 10. Sur l'exemple de la figure 1, le convertisseur 100 comporte des relais 120 de connexion au réseau 10 formant une interface entre les sorties des circuits de filtrage et le réseau 10. Sur la figure 1, les signaux de commande des relais 120 sont appelés « grid relays ».

Le convertisseur 100 selon le premier exemple comporte en outre des premiers interrupteurs de mesure 122 chacun couplé électriquement entre la deuxième électrode de l'une des premières inductances 113 et l'élément capacitif formé par les capacités 112. Dans l'exemple de la figure 1, le convertisseur 100 comporte trois premiers interrupteurs de mesure 122. Sur la figure 1, les lettres « a », « b » et « c » désignent les points de connexion entre une première électrode des premiers interrupteurs de mesure 122 et les circuits de filtrage. Sur la figure 1, le signal de commande des premiers interrupteurs de mesure 122 est appelé SW1.

Sur l'exemple de la figure 1, les deuxièmes électrodes des premiers interrupteurs de mesure 122 sont couplées électriquement entre elles et à la deuxième électrode de la capacité 112 qui est couplée également aux deuxièmes interrupteurs 106 des cellules de commutation 102.1 - 102.3. Cette configuration permet de transférer une quantité importante d'énergie aux premières inductances 113. En variante, les deuxièmes électrodes des premiers interrupteurs de mesure 122 peuvent être couplées électriquement au noeud formant le point milieu du bus assurant la connexion entre le panneau 1002 et le convertisseur 100.

Les premiers interrupteurs de mesure 122 sont destinés à être commandés pour réaliser une mesure de la valeur de chacune des premières inductances 113. De plus, sur l'exemple de la figure 1, les premiers interrupteurs de mesure 122 sont configurés pour être commandés par un seul et même signal de commande SW1. Selon un premier exemple, les premiers interrupteurs de mesure 122 peuvent correspondre à un contacteur à X phases (avec X correspondant au nombre de phases du convertisseur 100, c'est-à-dire trois sur l'exemple de la figure 1) doté de 2X pôles et 1 bobine. Selon un deuxième exemple, les premiers interrupteurs de mesure 122 peuvent être formés par des composants semi-conducteurs de puissance formant des interrupteurs unidirectionnels en courant, comme par exemple des transistors tels que des IGBT, chacun couplé électriquement en série à une diode.

Dans le premier exemple décrit, le convertisseur 100 comporte en outre des deuxièmes interrupteurs de mesure 124 chacun couplé électriquement entre une deuxième électrode de l'une des deuxièmes inductances 114 et l'élément capacitif formé par les capacités 112. Sur le schéma de la figure 1, le convertisseur 100 comporte trois deuxièmes interrupteurs de mesure 124. Sur la figure 1, les lettres « a' », « b' » et « c' » désignent les points de connexion entre les deuxièmes interrupteurs de mesure 124 et les circuits de filtrage. Sur la figure 1, le signal de commande des deuxièmes interrupteurs de mesure 124 est appelé SW2.

Sur l'exemple de la figure 1, les deuxièmes électrodes des deuxièmes interrupteurs de mesure 124 sont couplées électriquement entre elles et à la deuxième électrode de la capacité 112 qui est couplée aux deuxièmes interrupteurs de commutation 106 (configuration permettant un transfert important d'énergie aux deuxièmes inductances 114). En variante, les deuxièmes électrodes des deuxièmes interrupteurs de mesure 124 peuvent être couplées électriquement au noeud formant le point milieu du bus assurant la connexion entre le panneau 1002 et le convertisseur 100.

Les deuxièmes interrupteurs de mesure 124 sont destinés à être commandés pour réaliser une mesure de la valeur de chacune des deuxièmes inductances 114. Sur l'exemple de la figure 1, comme pour les premiers interrupteurs de mesure 122, les deuxièmes interrupteurs de mesure 124 sont configurés pour être commandés par un seul et même signal de commande SW2.

Le convertisseur 100 comporte en outre un circuit de pilotage 126 configuré pour commander l'ouverture et la fermeture de chacun des premiers et deuxièmes interrupteurs de commutation 104, 106, ainsi que l'ouverture et la fermeture de chacun des premiers et deuxièmes interrupteurs de mesure 122, 124. Sur l'exemple de la figure 1, le circuit de pilotage 126 est également configuré pour commander l'ouverture et la fermeture des relais 120.

Le convertisseur 100 décrit dans cet exemple comporte en outre un circuit de calcul 128 de la valeur de chacune des premières et deuxièmes inductances 113, 114 à partir de la valeur de la tension d'entrée $V_{cbus}$ mesurée par le circuit 111 et des valeurs des courants mesurés par les circuits 118.

Le calcul de la valeur de chacune des premières et deuxièmes inductances 113, 114 correspond à une possibilité pour identifier les éventuelles défaillances de la ou des inductances du ou des circuits de filtrage. D'autres manières d'identifier ces éventuelles défaillances sont possibles.

Selon un exemple de réalisation, le circuit de pilotage 126 et le circuit de calcul 128 peuvent comporter un même microprocesseur ou FPGA recevant en entrée la valeur de la tension d'entrée $V_{cbus}$ mesurée par le circuit 111 ainsi que les valeurs des courants mesurés par les circuits 118, et délivrant en sortie les signaux de commande des interrupteurs de commutation 104, 106, des interrupteurs de mesure 122, 124 et des relais 120. Sur la figure 1, les liaisons électriques entre les circuits 126, 128 et les autres éléments du convertisseur 100 ne sont pas représentées.

Dans l'exemple de la figure 1, le convertisseur 100 est configuré pour réaliser une conversion de courant ou de tension avec d'un côté une tension continue destinée à être obtenue aux bornes de l'élément capacitif, et de l'autre des tensions triphasées destinées à être obtenues en sortie de chacun des circuits de filtrage. A titre d'exemple, le convertisseur 100 peut correspondre à un onduleur de tension et/ou un redresseur de courant triphasé assurant la conversion entre une source de tension continue, par exemple un panneau photovoltaïque, couplée à l'élément capacitif du convertisseur 100, et des tensions triphasées par exemple destinées à être injectées et/ou reçues sur un réseau ou une machine tournante telle qu'un moteur et obtenues en sortie des circuits de filtrage.

En dotant le convertisseur 100 des interrupteurs de mesure 122, 124 et en configurant le circuit de pilotage 126 et le circuit de calcul 128 de manière appropriée, il est possible de suivre l'état de santé des inductances 113, 114 des circuits de filtrage afin de détecter une éventuelle défaillance de ces inductances 113, 114. Pour cela, l'évolution de la valeur de ces inductances dans le temps va être suivie. Un exemple d'étapes mises en oeuvre par le convertisseur 100 pour réaliser ce suivi est décrit ci-dessous.

La nuit, en l'absence de lumière, le panneau photovoltaïque 1002 ne produit pas d'énergie électrique et le convertisseur 100 est à l'arrêt. Les interrupteurs de commutation 104, 106 des cellules de commutation 102.1 - 102.3 sont à l'état ouvert.

Ensuite, en présence de lumière, le panneau photovoltaïque 1002 produit de l'énergie électrique, ce qui se traduit par l'apparition d'une tension aux bornes du panneau 1002. L'élément capacitif formé par les capacités 112 se charge électriquement grâce à cette tension.

Lorsque l'élément capacitif est suffisamment chargé électriquement, ce qui peut se traduire par le fait d'avoir la tension $V_{cbus} > V_{seuil}$, avec $V_{seuil}$ correspondant à une valeur seuil prédéfinie, des mesures des valeurs des inductances 113, 114 sont réalisées.

La mesure de la valeur d'une des premières inductances 113 est tout d'abord réalisée. Pour cela, le premier interrupteur de mesure 122 couplé à cette première inductance 122 est fermé. Dans le cas de l'exemple représenté sur la figure 1, étant donné que tous les premiers interrupteurs de mesure 122 sont commandés par un même signal de commande SW1, la fermeture (ou l'ouverture) de l'un des premiers interrupteurs de mesure 122 entraîne la fermeture (ou l'ouverture) des autres premiers interrupteurs de mesure 122. En outre, étant donné que les interrupteurs de commutation 104, 106 des cellules de commutation 102.1 - 102.3 sont ouverts à ce stade, cette fermeture des premiers interrupteurs de mesure 122 est réalisé à zéro de courant.

Le premier interrupteur de commutation 104 de la cellule de commutation associée à la première inductance 113 dont la valeur est mesurée est ensuite fermé pendant une première partie de la mesure de la valeur de cette première inductance 113 dont la durée $T_{on}$ (en secondes) peut être calculée au préalable selon l'équation :

[Math 1]

$$T_{on} = \alpha \times \frac{L_{initiale} \times \Delta Imax}{Vcbus}$$

avec $L_{initiale}$ correspondant à la valeur initiale de la première inductance 113 (en H), c'est-à-dire la valeur de la première inductance 113 avant vieillissement, c'est-à-dire en l'absence de défaillance ;

$\Delta Imax$ correspondant à la valeur maximale du courant (en A) destiné à traverser la première inductance 113 lors de la première partie de la mesure de la valeur de la première inductance 113 ;

$V_{cbus}$ correspondant à la tension (en V) aux bornes de l'élément capacitif formé par les capacités 112 ;

$\alpha$ correspondant à un coefficient supérieur à 0, et inférieur ou égal à 1.

Selon un exemple, en choisissant des premières et deuxièmes inductances 113, 114 chacune de valeur initiale (sans défaut) égale à 200 µH, une valeur $\Delta Imax$ égale à 350 A, une tension $V_{cbus}$ égale à 1,4 kV et un coefficient $\alpha$ égal à 1, la durée $T_{on}$ est égale à 50 µs.

Lorsque la valeur du coefficient $\alpha$ est inférieure à 1, ce coefficient correspond à une marge de sécurité appliquée sur la durée $T_{on}$ pour éviter tout risque de saturation de la première inductance 113.

Ce calcul de la durée $T_{on}$ est par exemple réalisé par le circuit de calcul 128.

Pendant une partie $\Delta t$ de cette durée $T_{on}$, la variation $\Delta i$ du courant traversant la première inductance 113 est mesurée par le circuit 118 couplé à cette première inductance 113.

Après la durée $T_{on}$, le premier interrupteur de commutation 104 de la cellule de commutation associée à la première inductance 113 dont la valeur est mesurée est ouvert pendant une deuxième partie de la mesure de la valeur de cette première inductance 113. La première inductance 113 se décharge en courant, la continuité de ce courant étant, dans cet exemple, assurée par la diode antiparallèle du deuxième interrupteur 106 de la cellule de commutation associée à la première inductance 113 dont la valeur est mesurée. Une durée $T_{décharge}$ de cette deuxième partie de la mesure de la valeur de la première inductance 113 peut être calculée au préalable, par exemple par le circuit de calcul 128. Par exemple, la durée $T_{décharge}$ peut être calculée selon l'équation :

[Math 2]

$$T_{décharge} = \left(\frac{E}{R}\right)^{-\frac{t}{to}}$$

avec E/R correspondant au courant maximum $I_{max}$ atteint, et « to » correspond au rapport L/R, L étant la valeur d'inductance à mesurer et R représentant la résistance équivalente (ou résistance dynamique compte tenu de la diode présente) de la maille totale de la roue libre passant par la diode de l'interrupteur 106. Le courant I(t) obtenu peut s'exprimer par l'équation suivante :

[Math 3]

$$I(t) = Imax^{-\frac{t}{L/R}}$$

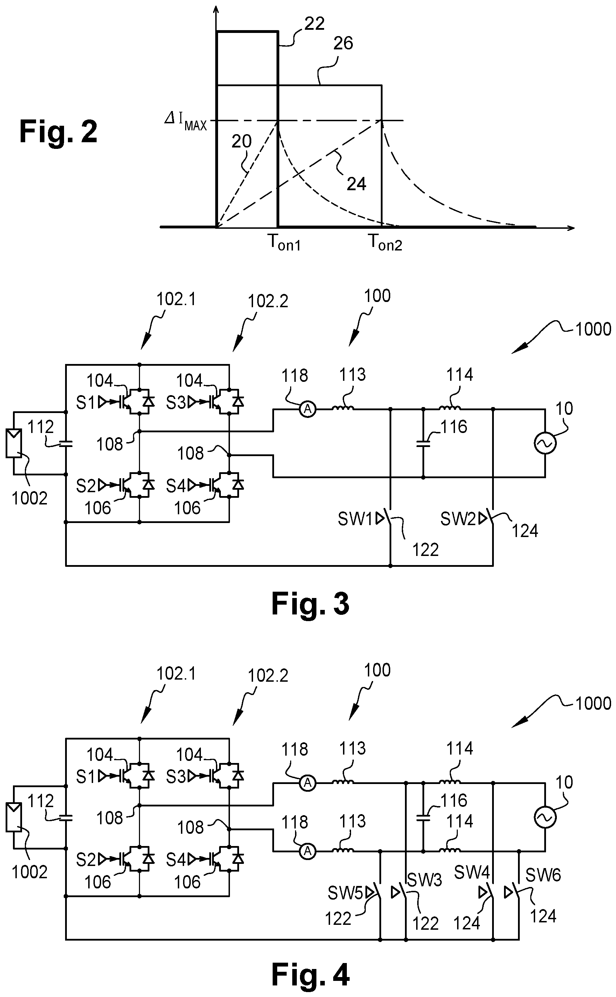

La courbe 20 représentée sur la figure 2 correspond à la variation de courant obtenue dans une des premières inductances 113 pour une tension $V_{cbus}$ désignée par la référence 22. Dans cet exemple, la charge en courant de cette première inductance 113 est réalisée pendant une durée $T_{on1}$, permettant au courant d'atteindre la valeur $\Delta Imax$. La courbe 24 correspond à la variation de courant obtenue dans cette même première inductance 113 pour une tension $V_{cbus}$ désignée par la référence 26 et dont la valeur est inférieure à celle désignée par la référence 22. Dans ce deuxième cas, la durée $T_{on2}$ nécessaire pour que le courant atteigne la valeur $\Delta Imax$ est supérieure à $T_{on1}$.

La valeur, appelée $L_{calc}$, de la première inductance 113 peut être calculée par le circuit de calcul 128 selon l'équation :

[Math 4]

$$L_{calc} = V_{cbus} \times \frac{\Delta t}{\Delta i}$$

La valeur $L_{calc}$ est par exemple calculée au cours de la première partie de la mesure de la valeur de la première inductance 113, c'est-à-dire pendant la charge en courant de cette première inductance 113.

A l'issue de la première partie de la mesure de la valeur de la première inductance 113, les étapes ci-dessus sont répétées pour chacune des phases du convertisseur 100 de manière à obtenir les valeurs de chacune des premières inductances 113.

Les valeurs des premières inductances 113 obtenues peuvent être enregistrées dans une mémoire du convertisseur 100 et comparées avec des valeurs précédemment calculées, par exemple des valeurs des premières inductances 113 calculées le jour précédent. Pour chacune des premières inductances 113, si la différence entre la valeur d'inductance calculée le jour j et celle calculée le jour j-1 est supérieure à une valeur seuil (dont la valeur est par exemple fonction des caractéristiques électriques de la première inductance 113), il est possible de signaler à l'utilisateur la présence d'un défaut d'isolation pour cette première inductance 113 et/ou de mettre en oeuvre une ou plusieurs autres mesures découlant de l'identification de ce problème.

Les étapes décrites ci-dessus pour mesurer les valeurs des premières inductances 113 sont ensuite répétées pour mesurer les valeurs des deuxièmes inductances 114, en commutant cette fois non pas les premiers interrupteurs de mesure 122 mais les deuxièmes interrupteurs de mesure 124. En outre, la valeur $L_{calc2}$ de chacune des deuxièmes inductances 114 peut être calculée par le circuit de calcul 128 selon l'équation :

[Math 5]

$$L_{calc2} = V_{cbus} \times \frac{\Delta t2}{\Delta i2} - L_{calc}$$

avec $\Delta i2$ correspondant à la variation du courant traversant la deuxième inductance 114 pendant la durée $\Delta t2$. La valeur $V_{cbus}$ peut être similaire ou différente de celle pendant la mesure de la valeur des premières inductances 113.

Comme pour les premières inductances 113, les valeurs des deuxièmes inductances 114 obtenues peuvent être enregistrées dans une mémoire du convertisseur 100 et comparées avec des valeurs précédemment calculées, par exemple des valeurs des deuxièmes inductances 114 calculées le jour précédent. Pour chacune des deuxièmes inductances 114, si la différence entre valeur d'inductance calculée le jour j et celle calculée le jour j-1 est supérieure à une valeur seuil (dont la valeur est par exemple fonction des caractéristiques électriques de la deuxième inductance 114), il est possible de signaler à l'utilisateur la présence d'un défaut d'isolation pour cette deuxième inductance 114 et/ou de mettre en oeuvre une ou plusieurs autres mesures découlant de l'identification de ce problème.

A l'issue des mesures des valeurs des premières et deuxièmes inductances 113, 114, le convertisseur 100 peut être démarré dans un mode de fonctionnement « classique », c'est-à-dire réalisant une conversion du signal électrique continu d'entrée en un signal électrique alternatif de sortie. Ce démarrage peut notamment comporter la fermeture des relais 120 afin de coupler électriquement les sorties des circuits de filtrage du convertisseur 100 au réseau 10.

Le convertisseur 100 permet donc de mesurer la valeur de la ou des inductances présentes dans le ou les circuits de filtrage avant le début du fonctionnement du convertisseur 100, par exemple avec une périodicité de 1 ou plusieurs jours (d'autres périodicité sont toutefois possibles). Pour y parvenir, les interrupteurs semi-conducteurs de puissance des cellules de commutation et les interrupteurs de mesure sont pilotés pour appliquer la tension du bus couplé en entrée du convertisseur 100 aux bornes de l'inductance dont la valeur est mesurée. Ainsi, un courant dit « de puissance » à di/dt constant (caractéristique obtenue en maintenant l'inductance dans un état non-saturé) traverse cette inductance pendant une courte période de temps. La valeur de l'inductance peut être calculée ensuite à partir de la pente du courant traversant l'inductance.

Le suivi de la valeur L d'une inductance est directement lié au nombre de spires N de l'inductance par l'équation suivante :

[Math 6]

$$L = \frac{N^2}{Reluctance\_noyau}$$

Ainsi, si des courts-circuits inter-spire ont lieu (avec n spires court-circuitées), la valeur de l'inductance décroît proportionnellement selon le facteur $(N-n)^2$. Pour cette raison, le convertisseur 100 décrit ci-dessus permet de réaliser un suivi de l'état de santé d'une inductance via le suivi de la valeur de l'inductance.

Les premiers et deuxièmes interrupteurs de mesure 122, 124 peuvent être choisis avec un faible calibre en courant et sans pouvoir de coupure, ce qui permet de choisir des interrupteurs peu coûteux. Par contre, les premiers et deuxièmes interrupteurs de mesure 122, 124 peuvent être choisis avec un calibre en tension dont la valeur dépend du réseau et qui soient pilotables à la fermeture et à l'ouverture par le circuit de pilotage 126 du convertisseur 100.

Dans l'exemple de réalisation décrit ci-dessus, le convertisseur 100 comporte plusieurs phases de sortie. Selon un deuxième exemple de réalisation décrit ci-dessous en lien avec la figure 3, le convertisseur 100 peut être monophasé.

Ainsi, par rapport au convertisseur 100 précédemment décrit en lien avec la figure 1, le convertisseur 100 représenté sur la figure 3 comporte deux cellules de commutation 102.1, 102.2, chacune par exemple similaire aux cellules de commutation du convertisseur 100 selon le premier exemple.

Le convertisseur 100 selon ce deuxième exemple comporte un seul circuit de filtrage, par exemple de type LCL comme dans le premier exemple de réalisation précédemment décrit. Ce circuit de filtrage est couplé au noeud central 108 de la première cellule de commutation 102.1 à travers un circuit 118 de mesure de courant. Le noeud central 108 de la deuxième cellule de commutation 102.2 est couplée à la deuxième électrode de la capacité 116 et au réseau 10.

Le convertisseur 100 selon ce deuxième exemple de réalisation comporte un seul premier interrupteur de mesure 122 utilisé pour la mesure de la première inductance 113 du circuit de filtrage et un seul deuxième interrupteur de mesure 124 utilisé pour la mesure de la deuxième inductance 114 du circuit de filtrage. En outre, l'élément capacitif du convertisseur 100 selon ce deuxième exemple de réalisation ne comporte qu'une seule capacité 112.

Bien que non représentés sur la figure 3, le convertisseur 100 comporte également dans cet exemple des circuits 110 de commande de grille, des relais 120 de connexion au réseau 10, un circuit de pilotage 126 et un circuit de calcul 128.

Le fonctionnement du convertisseur 100 selon ce deuxième exemple de réalisation est par exemple similaire à celui du convertisseur 100 selon le premier exemple de réalisation. En particulier, les étapes mises en oeuvre pour mesurer les valeurs des première et deuxième inductances 113, 114 peuvent être similaires à celles précédemment décrites pour le convertisseur 100 selon le premier exemple de réalisation.

Les différentes possibilités et variantes de réalisation précédemment décrites pour le convertisseur 100 selon le premier exemple peuvent s'appliquer également au convertisseur 100 selon ce deuxième exemple.

Un troisième exemple de réalisation d'un convertisseur 100, ici monophasé, est décrit ci-dessous en lien avec la figure 4.

Par rapport au convertisseur 100 précédemment décrit en lien avec la figure 3, un deuxième circuit de filtrage est présent sur la branche du circuit couplée au noeud central 108 de la deuxième cellule de commutation 102.2. Pour réaliser les mesures des inductances 113, 114 de ces deux circuits de filtrage, le convertisseur 100 comporte deux premiers interrupteurs de mesure 122 et deux deuxièmes interrupteurs de mesure 124. Dans ce troisième exemple, les interrupteurs de mesure 122, 124 sont commandables indépendamment les uns des autres par des signaux de commande référencés SW3, SW4, SW5 et SW6 sur la figure 4 (signaux délivrés en sortie du circuit de pilotage 126 non visible sur la figure 4).

Bien que non représentés sur la figure 4, le convertisseur 100 comporte également dans cet exemple des circuits 110 de commande de grille, des relais 120 de connexion au réseau 10, un circuit de pilotage 126 et un circuit de calcul 128.

Le fonctionnement du convertisseur 100 selon ce troisième exemple de réalisation est par exemple similaire à celui du convertisseur 100 selon le premier exemple de réalisation. En particulier, les étapes mises en oeuvre pour mesurer successivement les valeurs des premières et deuxièmes inductances 113, 114 peuvent être similaires à celles précédemment décrites pour le convertisseur 100 selon le premier exemple de réalisation.

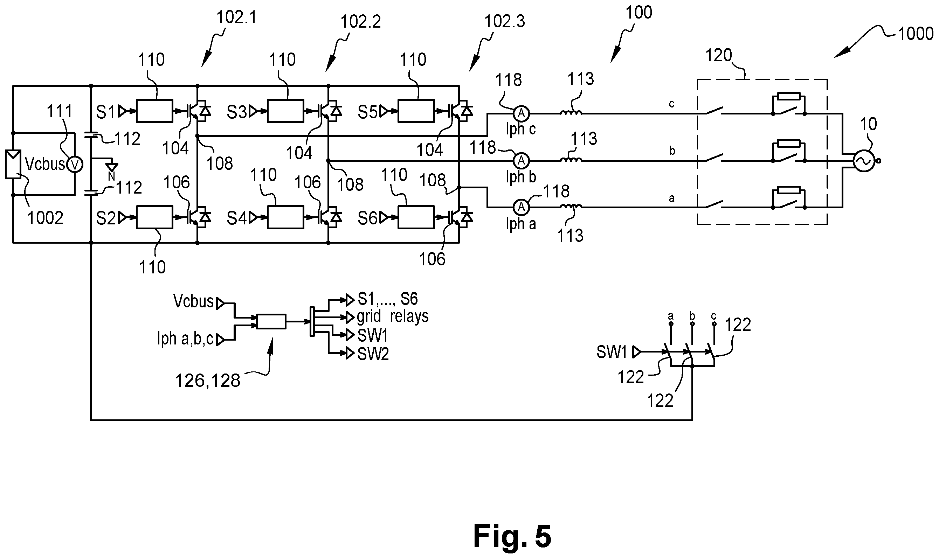

Un quatrième exemple de réalisation d'un convertisseur 100 est décrit ci-dessous en lien avec la figure 5.

Par rapport au convertisseur 100 précédemment décrit en lien avec la figure 1, chacun des circuits de filtrage ne comporte qu'une seule inductance 113. Pour réaliser les mesures des premières inductances 113, le convertisseur 100 ne comporte que les premiers interrupteurs de mesure 122.

Le fonctionnement du convertisseur 100 selon ce quatrième exemple de réalisation est par exemple similaire à celui du convertisseur 100 selon le premier exemple de réalisation, les étapes mises en oeuvre pour mesurer successivement les valeurs des premières inductances 113 peuvent être similaires à celles précédemment décrites pour le convertisseur 100 selon le premier exemple de réalisation.

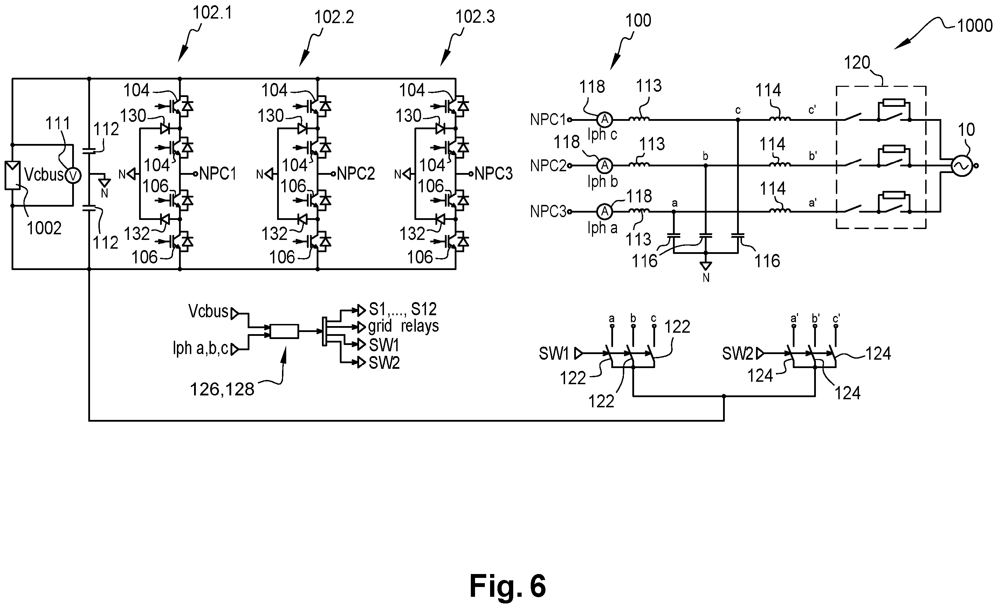

Un cinquième exemple de réalisation d'un convertisseur 100 est décrit ci-dessous en lien avec la figure 6.

Comme dans l'exemple précédemment décrit en lien avec la figure 1, le convertisseur 100 selon ce cinquième exemple de réalisation correspond à un onduleur triphasé comprenant trois circuits de filtrage de type LCL, trois premiers interrupteurs de mesure 122 et trois deuxièmes interrupteurs de mesure 124 permettant de réaliser les mesures des valeurs des première et deuxième inductances 113, 114 de chacun des circuits de filtrage. Sur la figure 6, les circuits 110 ne sont pas représentés

Par rapport au convertisseur 100 de la figure 1, le convertisseur 100 selon ce cinquième exemple de réalisation est un convertisseur multiniveau de type NPC (« Neutral Point Clamped » en anglais). Dans cette configuration, chaque cellule de commutation 102.1 - 102.3 comporte deux premiers interrupteurs de commutation 104 couplés à une première diode 130 et deux deuxièmes interrupteurs de commutation 106 couplés à une deuxième diode 132. Les signaux de commande de ces interrupteurs de commutation sont appelés $S_1$, ..., $S_{12}$ et sont délivrés en sortie du circuit de pilotage 126.

Le fonctionnement du convertisseur 100 selon ce cinquième exemple de réalisation est par exemple similaire à celui du convertisseur 100 selon le premier exemple de réalisation, les étapes mises en oeuvre pour mesurer successivement les valeurs des premières inductances 113 et des deuxièmes inductances 114 peuvent être similaires à celles précédemment décrites pour le convertisseur 100 selon le premier exemple de réalisation.

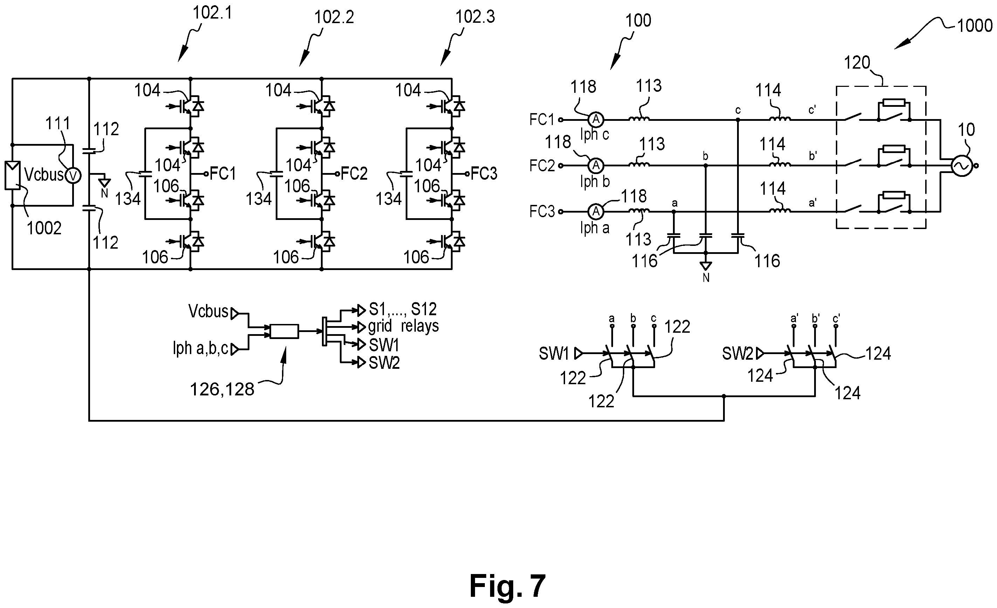

Un sixième exemple de réalisation d'un convertisseur 100 est décrit ci-dessous en lien avec la figure 7.

Comme dans l'exemple précédemment décrit en lien avec la figure 1, le convertisseur 100 selon ce sixième exemple de réalisation correspond à un onduleur triphasé comprenant trois circuits de filtrage de type LCL, trois premiers interrupteurs de mesure 122 et trois deuxièmes interrupteurs de mesure 124 permettant de réaliser les mesures des valeurs des première et deuxième inductances 113, 114 de chacun des circuits de filtrage. Sur la figure 7, les circuits 110 ne sont pas représentés

Par rapport au convertisseur 100 de la figure 1, le convertisseur 100 selon ce sixième exemple de réalisation est un convertisseur multiniveau de type à condensateurs flottants (« Flying-Capacitor » en anglais). Dans cette configuration, chaque cellule de commutation 102.1 - 102.3 comporte deux premiers interrupteurs de commutation 104 et deux deuxièmes interrupteurs de commutation 106 couplés à une capacité 134. Les signaux de commande de ces interrupteurs de commutation sont appelés $S_1$, ..., $S_{12}$.

Le fonctionnement du convertisseur 100 selon ce sixième exemple de réalisation est par exemple similaire à celui du convertisseur 100 selon le premier exemple de réalisation, les étapes mises en oeuvre pour mesurer successivement les valeurs des premières inductances 113 et des deuxièmes inductances 114 peuvent être similaires à celles précédemment décrites pour le convertisseur 100 selon le premier exemple de réalisation.

Dans tous les exemples de réalisation, le convertisseur 100 peut comporter d'autres composants et/ou circuits que ceux précédemment décrits.

Dans les exemples de réalisation précédemment décrits, chaque interrupteur de commutation comporte au moins un transistor de type IGBT. En variante, chaque interrupteur de commutation peut comporter au moins un transistor de type MOSFET. D'autres exemples d'interrupteurs de commutation sont possibles : utilisation de commutateurs autres que des transistors, utilisation de transistors autres que des MOSFET et/ou des IGBT, interrupteurs comprenant différents types de transistors, utilisation de transistor (s) de type N ou P, etc.

Dans tous les exemples de réalisation, les interrupteurs de commutation et/ou les interrupteurs de mesure peuvent comporter des composants de puissance verticaux, par exemple à base de semi-conducteur à grand gap, ou large bande, tel que du SiC et/ou du GaN. L'utilisation de composants à base de semi-conducteur à grand gap pour former les interrupteurs peut permettre d'avoir des vitesses de commutation des interrupteurs plus importantes qu'avec d'autres types de composants.

Dans tous les exemples de réalisation, le convertisseur 100 peut être de type DC/AC tel qu'un commutateur ou onduleur de courant (ou CSI pour « Current Source Inverter » en anglais, ou « Boost Type Inverter »), ou AC/AC si le convertisseur 100 comporte un élément capacitif tel que décrits dans les précédents exemples de réalisation.

Dans tous les exemples de réalisation, les composants des interrupteurs de puissance peuvent fonctionner en commutation (état ouvert ou fermé, ou état saturé ou bloqué) avec une fréquence de commutation élevée, par exemple comprise entre quelques kHz et une centaine de kHz.

Dans les différents exemples de réalisation précédemment décrits, les valeurs d'inductance calculées sont comparées avec des valeurs d'inductance précédemment calculées pour réaliser un suivi de l'état de santé des inductances des circuits de filtrage. En variante, il est possible de calculer une ou des valeurs de la ou des inductances du ou des circuits de filtrage, puis de comparer cette ou ces valeurs avec une ou plusieurs valeurs nominales correspondant aux valeurs d'inductances sans défaut, par exemple mesurées lors d'un test d'usine avant l'utilisation du convertisseur 100.

Dans les exemples de réalisation précédemment décrits, le courant utilisé pour déterminer la valeur d'une des inductances est mesuré lors de la première partie de la phase de mesure de la valeur de l'inductance, c'est-à-dire lors de la charge en courant dans l'inductance. En variante, il est possible de mesurer ce courant lors de la deuxième partie de la mesure de la valeur de l'inductance, c'est-à-dire lors de la décharge en courant de l'inductance. Dans ce cas, les calculs réalisés pour obtenir la valeur de l'inductance sont adaptés afin de tenir compte de la non linéarité de cette décharge en courant.

En variante des exemples de réalisation précédemment décrits, lorsque le convertisseur 100 comporte plusieurs premiers interrupteurs de mesure 122 et/ou plusieurs deuxièmes interrupteurs de mesure 124, il est possible que ces interrupteurs 122 et/ou 124 soient commandés séparément et non par un même signal de commande.

En variante des exemples de réalisation précédemment décrits dans lesquels le convertisseur 100 comporte des circuits de filtrage comprenant une ou plusieurs premières inductances et une ou plusieurs deuxièmes inductances dont les valeurs sont mesurées, il est possible de mesurer la ou les valeurs de la ou des premières inductances uniquement, ou mesurer la ou les valeurs de la ou des deuxièmes inductances uniquement. Selon une autre variante, il est possible de mesurer la ou les valeurs de la ou des deuxièmes inductances avant de mesurer la ou les valeurs de la ou des premières inductances.

Dans les exemples de réalisation précédemment décrits, le convertisseur 100 comporte plusieurs cellules de commutation. En variante, il est possible que le convertisseur 100 comporte une seule cellule de commutation.

En variante des différents exemples de réalisation précédemment décrits, il est possible que le convertisseur 100 fasse partie d'un système de puissance ne correspondant pas à un système photovoltaïque, c'est-à-dire un système de puissance dans lequel le signal électrique d'entrée ne soit pas produit par un ou plusieurs panneaux photovoltaïques.

Dans tous les exemples de réalisation du convertisseur 100, la précision de la mesure d'inductance réalisée dépend directement de la précision des circuits de mesure de tension et de courant utilisés. Ces circuits peuvent dont être choisis tels que leur précision soit en adéquation avec la précision attendue sur la mesure d'inductance réalisée.

Dans tous les exemples de réalisation du convertisseur 100, tous les composants exceptés les premiers interrupteurs de mesure 122 et/ou les deuxièmes interrupteurs de mesure 124 peuvent être présents dans un convertisseur statique de puissance standard. Outre l'ajout de ce ou ces interrupteurs 122, 124, la réalisation du convertisseur 100 implique de réaliser un paramétrage du circuit de commande 126 et du circuit de calcul 128 permettant de commander ce ou ces interrupteurs et de réaliser les calculs des valeurs des inductances.

Dans tous les exemples de réalisation du convertisseur 100, les valeurs des inductances 113, 114 peuvent être mesurées via des mesures de courants traversant ces inductances 113, 114, puis un calcul des valeurs des inductances 113, 114 réalisé à partir des mesures de courants.

Dans tous les exemples de réalisation du convertisseur 100, les interrupteurs de mesure permettent de ne pas avoir à réaliser des mesures en continue pour détecter d'éventuelles défaillances de la ou des inductances du ou des circuits de filtrage au sein du convertisseur 100. De plus, cette détection peut être réalisée sans avoir à passer par une détermination de la fréquence de résonance d'un circuit LC nécessitant la présence d'au moins une capacité couplée à la ou aux inductances.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en oeuvre pratique des modes de réalisation et variantes décrits est à la portée de la personne du métier à partir des indications fonctionnelles données ci-dessus.

## Revendications

1. Convertisseur statique de puissance (100), comportant au moins :

   - une cellule de commutation (102.1 - 102.3) comprenant au moins des premier et deuxième interrupteurs de commutation (104, 106) ;
   - une première inductance (113) couplée à une sortie de la cellule de commutation (102.1 - 102.3) ;

- un premier interrupteur de mesure (122) tel que la première inductance (113) soit couplée entre le premier interrupteur de mesure (122) et la cellule de commutation (102.1 - 102.3) ;
- un circuit de pilotage (126) configuré pour commander au moins une fermeture du premier interrupteur de mesure (122) lors d'une mesure d'une valeur de la première inductance (113).

2. Convertisseur statique de puissance (100) selon la revendication 1, comportant en outre au moins :

- un élément capacitif (112) couplé électriquement en parallèle de la cellule de commutation (102.1 - 102.3) et sur lequel une tension d'entrée est destinée à être appliquée ;
- un circuit de mesure de courant (118) configuré pour mesurer un courant destiné à traverser la première inductance (113) ;

et dans lequel :

- la cellule de commutation (102.1 - 102.3) comprend un noeud central (108) auquel les premier et deuxième interrupteurs de commutation (104, 106) sont couplés électriquement ;
- la première inductance (113) comprend une première électrode couplée au noeud central (108) de la cellule de commutation (102.1 - 102.3) ;
- le premier interrupteur de mesure (122) est couplé électriquement entre une deuxième électrode de la première inductance (113) et l'élément capacitif (112) ;
- le circuit de pilotage (126) est configuré pour commander les interrupteurs de commutation (104, 106) et le premier interrupteur de mesure (122) tel que lors d'une première partie de la mesure de la valeur de la première inductance (113), le premier interrupteur de mesure (122) et le premier interrupteur de commutation (104) sont fermés.

3. Convertisseur statique de puissance (100) selon la revendication 2, dans lequel le circuit de pilotage (126) est configuré pour commander les interrupteurs de commutation (104, 106) et le premier interrupteur de mesure (122) tel que lors d'une deuxième partie de la mesure de la valeur de la première inductance (113), le premier interrupteur de mesure (122) est fermé et le premier interrupteur de commutation (104) est ouvert.

4. Convertisseur statique de puissance (100) selon l'une des revendications 2 ou 3, comportant en outre un circuit de calcul (128) de la valeur de la première inductance (113) à partir de la valeur de la tension d'entrée et du courant mesuré par le circuit de mesure de courant (118) lors de la première partie de la mesure de la valeur de la première inductance (113) et/ou lors de la deuxième partie de la mesure de la valeur de la première inductance (113).

5. Convertisseur statique de puissance (100) selon la revendication 4, dans lequel le circuit de calcul (128) est configuré pour calculer la valeur de la première inductance (113) selon l'équation :

$$L_{calc} = V_{cbus} \times \frac{\Delta t}{\Delta i}$$

avec $V_{cbus}$ correspondant à la tension d'entrée aux bornes de l'élément capacitif (112) avant la mesure de la valeur de la première inductance (113) ;
$\Delta i$ correspondant à une variation de courant mesurée par le circuit de mesure de courant (118) ;
$\Delta t$ correspondant à une durée pendant laquelle la variation de courant $\Delta i$ est mesurée.

6. Convertisseur statique de puissance (100) selon l'une des revendications 4 ou 5, dans lequel le circuit de mesure de courant (118) est configuré pour mesurer le courant au cours de la première partie de la mesure de la valeur de la première inductance (113).

7. Convertisseur statique de puissance (100) selon l'une des revendications 4 à 6, dans lequel le circuit de calcul (128) est configuré pour comparer la valeur calculée de la première inductance (113) à au moins une valeur nominale de la première inductance (113) et/ou à au moins une précédente valeur calculée de la première inductance (113).

8. Convertisseur statique de puissance (100) selon l'une des revendications 4 à 7, dans lequel le circuit de calcul (128) est configuré pour calculer, avant la mesure de la valeur de la première inductance (113), une durée $T_{on}$ de la première partie de la mesure de la valeur de la première inductance (113) telle que :

$$T_{on} = \alpha \times \frac{L_{initiale} \times \Delta Imax}{V_{cbus}}$$

avec $L_{initiale}$ correspondant à la valeur initiale de la première inductance (113) ;
$\Delta Imax$ correspondant à la valeur maximale du courant destiné à traverser la première inductance (113) lors de la première partie de la mesure de la valeur de la première inductance (113) ;
$\alpha$ correspondant à un coefficient supérieur à 0, et inférieur ou égal à 1.

9. Convertisseur statique de puissance (100) selon l'une des revendications 2 à 8, comportant en outre un circuit de mesure de tension (111) configuré pour mesurer la tension d'entrée destinée à être appliquée sur l'élément capacitif (112), et dans lequel le circuit de pilotage (126) est configuré pour débuter la mesure de la valeur de la première inductance (113) lorsque la tension d'entrée mesurée est supérieure à une valeur seuil.

10. Convertisseur statique de puissance (100) selon l'une des revendications 2 à 9, dans lequel l'élément capacitif comporte au moins deux capacités (112) couplées électriquement en série au niveau d'un noeud, et dans lequel ledit noeud est couplé à un potentiel électrique de référence.

11. Convertisseur statique de puissance (100) selon l'une des revendications 2 à 10, dans lequel :

- la première inductance (113) fait partie d'un filtre de type LCL comportant en outre une deuxième inductance (114) dont une première électrode est couplée à la deuxième électrode de la première inductance (113) ;
- le convertisseur statique de puissance (100) comporte en outre un deuxième interrupteur de mesure (124) couplé électriquement entre une deuxième électrode de la deuxième inductance (114) et l'élément capacitif (112) ;
- le circuit de pilotage (126) est configuré pour commander également le deuxième interrupteur de mesure (124) tel que :

o lors des première et deuxième parties de la mesure de la valeur de la première inductance (113), le deuxième interrupteur de mesure (124) est ouvert ;
o lors d'une première partie d'une mesure de la deuxième inductance (114), le premier interrupteur de mesure (122) est ouvert, et le premier interrupteur de commutation (104) et le deuxième interrupteur de mesure (124) sont fermés.

12. Convertisseur statique de puissance (100) selon la revendication 11, dans lequel le circuit de pilotage (126) est configuré pour commander le deuxième interrupteur de mesure (124) tel que lors d'une deuxième partie de la mesure de la deuxième inductance (114), le premier interrupteur de mesure (122) et le premier interrupteur de commutation (104) sont ouverts, et le deuxième interrupteur de mesure (124) est fermé.

13. Convertisseur statique de puissance (100) selon l'une des revendications 2 à 12, comportant :

- trois cellules de commutation (102.1 - 102.3) comprenant chacune un noeud central (108) et au moins des premier et deuxième interrupteurs de commutation (104, 106) couplés électriquement en série l'un à l'autre, chacune étant couplée électriquement en parallèle de l'élément capacitif (112) ;
- trois premières inductances (113) comprenant chacune une première électrode couplée au noeud central (108) de l'une des cellules de commutation (102.1 - 102.3) ;
- trois circuits de mesure de courant (118) chacun configuré pour mesurer un courant destiné à traverser l'une des trois premières inductances (113) ;
- trois premiers interrupteurs de mesure (122) chacun couplé électriquement entre une deuxième électrode de l'une des premières inductances (113) et l'élément capacitif (112) ;

et dans lequel le circuit de pilotage (126) est configuré pour mesurer chacune des premières inductances (113) et pour commander les interrupteurs de commutation (104, 106) et les premiers interrupteurs de mesure (122) tel que lors d'une première partie d'une mesure de la valeur de l'une des premières inductances (113), le premier interrupteur de mesure (122) et le premier interrupteur de commutation (104) couplés à ladite une des premières inductances (113) sont fermés, et lors d'une deuxième partie de la mesure de la valeur de ladite une des premières inductances (113), le premier interrupteur de mesure (122) couplé à ladite une des premières inductances (113) est fermé et le premier interrupteur de commutation (104) couplé à ladite une des premières inductances (113) est ouvert.

**14.** Convertisseur statique de puissance (100) selon la revendication 13, dans lequel les premiers interrupteurs de mesure (122) sont configurés pour être commandés par un même signal de commande.

**15.** Convertisseur statique de puissance (100) selon l'une des revendications précédentes, configuré pour réaliser une mesure de la valeur de la première inductance (113) à des intervalles de temps réguliers, par exemple quotidiennement ou à intervalles de plusieurs jours.

**16.** Convertisseur statique de puissance (100) selon l'une des revendications précédentes, dans lequel le convertisseur statique de puissance (100) est un convertisseur multiniveau, par exemple de type NPC ou à condensateurs flottants, et fonctionnant en tant qu'onduleur ou redresseur de tension et/ou courant.

**17.** Système photovoltaïque (1000) comprenant au moins un panneau photovoltaïque (1002) couplé à un convertisseur statique de puissance (100) selon l'une des revendications précédentes.

**Fig. 1**

EP 4 572 122 A1

**Fig. 2**

**Fig. 3**

**Fig. 4**

Fig. 5

**Fig. 6**

EP 4 572 122 A1

**Fig. 7**

EP 4 572 122 A1

Europäisches
Patentamt

European
Patent Office

Office européen
des brevets

## RAPPORT DE RECHERCHE EUROPEENNE

Numéro de la demande

EP 24 21 7001

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2021/391813 A1 (MAHANKALI VENKATA PAVAN [IN] ET AL) 16 décembre 2021 (2021-12-16) | 1-7,9, 10,15-17 | INV. H02M7/5387 |
| A | * abrégé * * alinéa [0001] - alinéa [0052]; figures 1-7 * | 8,11-14 | H02M1/12 G01R31/40 |
| | ----- | | ADD. H02M7/487 |
| X | EP 3 544 173 A1 (UNIV SAARLAND [DE]) 25 septembre 2019 (2019-09-25) | 1-7,9, 10,15-17 | |
| A | * abrégé * * alinéa [0037] - alinéa [0081]; figures 1-10 * | 8,11-14 | |
| | ----- | | |
| X | AU 2020 400 935 A1 (FRONIUS INT GMBH [AT]) 14 juillet 2022 (2022-07-14) | 1-7,9, 10,15-17 | |
| A | * abrégé * * page 1 - page 13; figures 1-4 * | 8,11-14 | |
| | ----- | | |
| X | EP 3 595 159 A1 (HITACHI INDUSTRY EQUIPMENT SYSTEMS CO LTD [JP]) 15 janvier 2020 (2020-01-15) | 1-7,9, 10,15-17 | |
| A | * abrégé * * alinéa [0001] - alinéa [0074]; figures 1-29 * | 8,11-14 | DOMAINES TECHNIQUES RECHERCHES (IPC) H02M G01R |
| | ----- | | |
| X | US 2023/116269 A1 (WIESER STEFAN [AT] ET AL) 13 avril 2023 (2023-04-13) | 1-7,9, 10,15-17 | |
| A | * abrégé * * alinéa [0001] - alinéa [0066]; figures 1-9 * | 8,11-14 | |
| | ----- | | |
| X | US 2015/309119 A1 (BERROTERAN GIL IGOR [US] ET AL) 29 octobre 2015 (2015-10-29) | 1-7,9, 10,15-17 | |
| A | * abrégé * * alinéa [0001] - alinéa [0110]; figures 1-11 * | 8,11-14 | |
| | ----- | | |

Le présent rapport a été établi pour toutes les revendications

| Lieu de la recherche | Date d'achèvement de la recherche | Examinateur |
|---|---|---|
| La Haye | 25 février 2025 | Adami, Salah-Eddine |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 24 21 7001

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

25-02-2025

| Document brevet cité au rapport de recherche | Date de publication | Membre(s) de la famille de brevet(s) | Date de publication |
|---|---|---|---|
| US 2021391813 A1 | 16-12-2021 | CN 113809968 A | 17-12-2021 |
| | | US 2021391813 A1 | 16-12-2021 |
| EP 3544173 A1 | 25-09-2019 | DE 102018106796 A1 | 26-09-2019 |
| | | EP 3544173 A1 | 25-09-2019 |
| AU 2020400935 A1 | 14-07-2022 | AU 2020400935 A1 | 14-07-2022 |
| | | BR 112022011418 A2 | 30-08-2022 |
| | | CN 114930705 A | 19-08-2022 |
| | | EP 3836383 A1 | 16-06-2021 |
| | | EP 4073920 A1 | 19-10-2022 |
| | | ES 2958560 T3 | 09-02-2024 |
| | | IL 293765 A | 01-08-2022 |
| | | PL 4073920 T3 | 03-01-2024 |
| | | US 2023051498 A1 | 16-02-2023 |
| | | WO 2021116166 A1 | 17-06-2021 |
| EP 3595159 A1 | 15-01-2020 | CN 110249519 A | 17-09-2019 |
| | | EP 3595159 A1 | 15-01-2020 |
| | | JP 6765325 B2 | 07-10-2020 |
| | | JP 2018148711 A | 20-09-2018 |
| | | WO 2018163922 A1 | 13-09-2018 |
| US 2023116269 A1 | 13-04-2023 | AU 2021219955 A1 | 28-07-2022 |
| | | BR 112022010107 A2 | 06-09-2022 |
| | | CN 115088177 A | 20-09-2022 |
| | | EP 4046268 A1 | 24-08-2022 |
| | | ES 2946932 T3 | 28-07-2023 |
| | | IL 293422 A | 01-07-2022 |
| | | PL 4046268 T3 | 14-08-2023 |
| | | US 2023116269 A1 | 13-04-2023 |
| | | WO 2021160791 A1 | 19-08-2021 |
| US 2015309119 A1 | 29-10-2015 | AUCUN | |

EPO FORM P0460